# EUROPEAN PATENT APPLICATION

(11) **EP 4 339 323 A2**
(43) Date of publication of application: **20.03.2024**
(21) Application number: 23197351.2
(22) Date of filing: 14.09.2023
(51) Int. Cl.: C23C 16/44, H01J 37/32, H01L 21/67, H01L 21/673

(54) **GAS BOX ASSEMBLY FOR HIGH PRESSURE PROCESSING APPARATUS**

(30) Priority: 16.09.2022 KR 20220117259
(71) Applicant: HPSP Co., Ltd., Suwon-si, Gyeonggi-do (KR)
(72) Inventor: LIM, Kun Young, Suwon-si, Gyeonggi-do (KR); Yoon, Hyeseong, Suwon-si,Gyeonggi-do (KR)
(74) Representative: von Bülow & Tamada

(57) **Abstract**

Provided is a gas box assembly for a high pressure processing apparatus, the assembly including: a housing having an inner space; a supply module disposed in the inner space and supplying a process gas to a chamber of the high pressure processing apparatus; an exhaust module exhausting a gas occurring due to processing of an object in the chamber; and a charge module charging a protection gas into the inner space at a pressure higher than an external pressure of the housing to block external air from being introduced into the inner space.

## Description

### BACKGROUND

### Field

The present disclosure relates to a gas box assembly used to supply a gas to or exhaust a gas from a chamber of a high pressure processing apparatus.

### Description of the Related Art

In general, various processing may be performed on a semiconductor wafer during a manufacturing process of a semiconductor device. As an example of such processing, there is oxidation, nitridation, silicide, ion implantation, chemical vapor deposition (CVD) processes, or the like. There is also a hydrogen or deuterium heat treatment process to improve an interface property of the semiconductor device.

### SUMMARY

A gas used for the processing may be supplied to a chamber at a high pressure and act on the semiconductor wafer. The gas may be supplied to the chamber by a gas box and also be exhausted from the chamber.
If the gas leaks during processes of supplying or exhausting the gas, fire due to ignition may occur in addition to contamination of a surrounding area. As a temperature in the processing process is increased, a temperature of the exhausted gas may also be increased, thus increasing a risk of the ignition in the gas box. If the temperature in the processing is a spontaneous ignition temperature of the gas or more, the risk of the ignition due to the gas leak may become even greater.

An object of the present disclosure is to provide a gas box assembly for a high pressure processing apparatus which can structurally prevent a risk of ignition in a gas box due to gas leak during a processing process even when the process is performed at a high temperature.

According to an embodiment of the present disclosure, provided is a gas box assembly for a high pressure processing apparatus, the assembly including: a housing having an inner space; a supply module disposed in the inner space and supplying a process gas to a chamber of the high pressure processing apparatus; an exhaust module exhausting a gas occurring due to processing of an object in the chamber; and a charge module charging a protection gas into the inner space at a pressure higher than an external pressure of the housing to block external air from being introduced into the inner space.

A pressure of the inner space by the charging of the protection gas may have a value biased toward the external pressure rather than a pressure of the chamber by the supply of the process gas.

A pressure of the inner space by the charging of the protection gas may have a value lower than a pressure of the process gas flowing in the supply module.

The assembly may further include: a detection module detecting an environment of the inner space; and a control module controlling the charge module, wherein the control module controls the charge module based on a detection result of the detection module.

The detection module may include a pressure gauge, and the control module may control the charge module to charge the protection gas for the inner space to reach a set pressure when a pressure of the inner space detected by the pressure gauge is lower than the set pressure.

The assembly may further include: a detection module detecting an environment of the inner space; a discharge module discharging a gas from the inner space; and a control module controlling the discharge module, wherein the control module operates the discharge module when determining that a gas leaks from at least one of the supply module and the exhaust module to the inner space based on a detection result of the detection module.

The control module may control the charge module to charge the protection gas into the inner space to dilute the leaking gas during a discharge process of the gas from the inner space.

The charge module may include a gas regulation charger charging the protection gas into the inner space while regulating a flow rate of the protection gas.

The charge module may include an emergency open/close charger charging the protection gas at a maximum set flow rate into the inner space during the discharge process of the gas.

The detection module may include at least one of a pressure gauge and a gas detector, and the control module may determine that the gas leaks when a pressure of the inner space detected by the pressure gauge is higher than a set pressure or the gas detector detects the process gas.

The assembly may further include: a detection module detecting an environment of the inner space; an introduction module introducing external air into the inner space; and a control module controlling the introduction module, wherein the control module controls oxygen concentration in the inner space to reach set oxygen concentration by operating the introduction module based on the oxygen concentration in the inner space that is detected through the detection module.

The object may include a semiconductor wafer, the process gas may include at least one of hydrogen, deuterium, fluorine, ammonia, and chlorine, and the protection gas may include an inert gas.

According to another embodiment of the present disclosure, provided is a gas box assembly for a high pressure processing apparatus, the assembly including: a housing having an inner space; an exhaust module disposed in the inner space, and exhausting a gas occurring due to processing of an object in a chamber of the high pressure processing apparatus at a temperature higher than an ignition point of a process gas; and a charge module charging a protection gas into the inner space at a pressure higher than an external pressure of the housing to prevent influx of external air into the inner space.

The assembly may further include: a detection module detecting an environment of the inner space; a discharge module discharging a gas from the inner space; and a control module controlling the discharge module, wherein the control module operates the discharge module when determining that a gas leaks from the exhaust module to the inner space based on a detection result of the detection module.

The assembly may further include: a detection module detecting an environment of the inner space; an introduction module introducing external air into the inner space; and a control module controlling the introduction module, wherein the control module controls oxygen concentration in the inner space to reach set oxygen concentration by operating the introduction module based on the oxygen concentration in the inner space that is detected through the detection module.

### BRIEF DESCRIPTION OF THE DRAWINGS

FIG. 1 is a conceptual diagram of a gas box assembly for a high pressure processing apparatus according to an embodiment of the present disclosure.
FIG. 2 is a block diagram for explaining a control configuration of the gas box assembly for a high pressure processing apparatus of FIG. 1.
FIG. 3 is a conceptual diagram of a gas box assembly for a high pressure processing apparatus according to another embodiment of the present disclosure.
FIG. 4 is a flowchart for explaining a control method of the gas box assembly for a high pressure processing apparatus of FIG. 3.
FIG. 5 is a flowchart for explaining another control method of the gas box assembly for a high pressure processing apparatus of FIG. 3.

### DETAILED DESCRIPTION

Hereinafter, a gas box assembly for a high pressure heat treatment apparatus according to embodiments of the present disclosure is described in detail with reference to the accompanying drawings. Throughout the present disclosure, components that are the same as or similar to each other are denoted by reference numerals that are the same as or similar to each other, and a description thereof is replaced by the first description, even in a different embodiment.

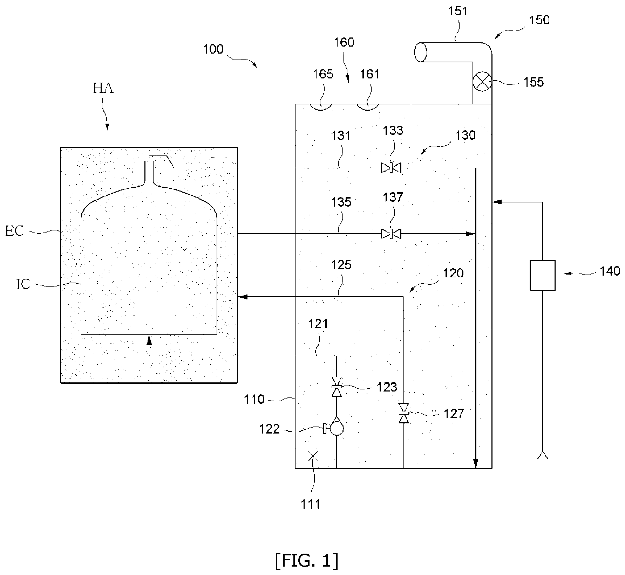

FIG. 1 is a conceptual diagram of a gas box assembly for a high pressure processing apparatus according to an embodiment of the present disclosure.

Referring to this drawing, a gas box assembly 100 for a high pressure processing apparatus may supply a gas to a high pressure processing apparatus HA and exhaust the gas therefrom.

The high pressure processing apparatus HA will first be explained as follows. The high pressure processing apparatus HA may have an internal chamber IC and an external chamber EC.

The internal chamber IC may form an accommodation space that accommodates an object to be processed. The internal chamber IC can be made of a non-metallic material, for example, quartz, to reduce contamination in a high pressure and high temperature working environment. Although simplified in the drawing, a door (not shown) for opening the accommodation space may be positioned at the bottom of the internal chamber IC. The accommodation space may be opened as the door descends, and the object may be injected into the internal chamber IC while being mounted on a holder (not shown). As a heater (not shown) disposed outside the internal chamber IC is operated, the internal chamber IC may be heated up to hundreds to thousands of degrees Celsius. Hydrogen may be heated up to 575 °C or more, which is its ignition point, when hydrogen is used as the gas input to the internal chamber IC based on a process temperature of the high-temperature process. The object may be, for example, a semiconductor wafer. In this case, the holder may be a wafer boat which may stack the semiconductor wafers in a plurality of layers.

The external chamber EC may surround the internal chamber IC. Unlike the internal chamber IC, the external chamber EC is free from a contamination problem, and the external chamber EC can thus be made of a metal material. The external chamber EC may also have a door at a lower portion, and the door of the external chamber EC can also descend and be opened when the door of the internal chamber IC is opened.

Hereinafter, the description describes the gas box assembly 100 as follows. The gas box assembly 100 may include a housing 110, a supply module 120, an exhaust module 130, a charge module 140, a discharge module 150, and a detection module 160.

The housing 110 may have an inner space 111. The housing 110 may have a substantially rectangular parallelepiped body. The housing 110 may have a door (not shown) through which a worker may approach the inner space 111 to replace/repair the supply module 120 described below. The supply module 120, the exhaust module 130, and the like may be installed in the inner space 111.

The supply module 120 may supply the gas to the high pressure processing apparatus HA, specifically to the chambers IC and EC. The supply module 120 may communicate with a utility line (or a gas supply line) of a semiconductor factory. The supply module 120 may have a first supply line 121 communicating with the internal chamber IC and a second supply line 125 communicating with the external chamber EC.

Through the first supply line 121, as the gas for processing the object, for example, hydrogen/deuterium, fluorine, ammonia, chlorine, nitrogen, or the like may be selectively supplied to the internal chamber IC. Through the second supply line 125, as an inert gas, for example, nitrogen or argon, can be supplied to the external chamber EC. The gas injected into the external chamber EC may be specifically supplied to a space between the external chamber EC and the internal chamber IC. Hydrogen or the like injected into the internal chamber IC and nitrogen or the like injected into the external chamber EC can all be collectively referred to as process gases. The reason is that a high-pressure processing process for the object may be performed by these gases.

The gas supplied to the internal chamber IC or the external chamber EC may be supplied to form a pressure higher than atmospheric pressure, for example, a high pressure ranging from several atmospheric pressures to tens of atmospheric pressures. When the pressure of the gas supplied to the internal chamber IC is a first pressure and the pressure of the gas supplied to the external chamber EC is a second pressure, the second pressure may be set in association with the first pressure. For example, the second pressure may be set to be substantially equal to or slightly greater than the first pressure. Such a pressure relationship may prevent a gas leak from the internal chamber IC and damage to the internal chamber IC.

A regulation supply 122 may be installed in the first supply line 121 to set and maintain the relationship between the first pressure and the second pressure. The regulation supply 122 may supply the gas while measuring an amount of the gas injected into the internal chamber IC. For example, the regulation supply 122 may be a mass flow controller (MFC) measuring a flow rate of the gas and calculating the injected amount. An open/close supply 123 may be installed downstream of the regulation supply 122 to open and close the first supply line 121. An open/close supply device 127 may be installed in the second supply line 125. Unlike the regulation supply 122, the open/close supply 127 may control the opening and closing based on the pressure of the external chamber EC without measuring the flow rate.

The exhaust module 130 may exhaust the gas occurring due to the processing of the object in the chamber IC or EC. The gas occurring due to the processing may be a mixed gas in which not only the process gas but also particles derived from the object are mixed. In addition, the gas occurring due to the processing may have a high temperature due to the high-temperature process. For example, the gas may be a gas having a temperature higher than the ignition point of the process gas. The exhaust module 130 may communicate with a utility line (or a gas exhaust line) of the semiconductor factory.

The exhaust module 130 may have a first exhaust line 131 for exhausting the gas from the internal chamber IC and a second exhaust line 135 for exhausting the gas from the external chamber EC. The first exhaust line 131 may communicate with an upper portion of the internal chamber IC and may also extend out of the external chamber EC. An exhaust valve 133 may be installed in the first exhaust line 131. The second exhaust line 135 may communicate with the external chamber EC and may also have an exhaust valve 137 installed therein. The second exhaust line 135 may be integrated into the first exhaust line 131. In this case, hydrogen exhausted along the first exhaust line 131 may be diluted with nitrogen exhausted along the second exhaust line 135, thus lowering its concentration.

The charge module 140 may charge a protection gas into the inner space 111. The protection gas may be, for example, an inert gas. The inert gas may include, for example, nitrogen or argon.

As the protection gas is charged, a pressure (or a third pressure) of the inner space 111 may have a different characteristic from the first pressure or the second pressure. The third pressure may be higher than an external pressure of the housing 110 (usually, the atmospheric pressure), and lower than the first pressure and the second pressure. In detail, the third pressure may have a value biased toward the external pressure rather than the first pressure and the second pressure, and may be slightly higher than the atmospheric pressure. For example, the third pressure may be a pressure higher by tens to hundreds of Pa than the atmospheric pressure. It may be sufficient that the third pressure is set to a level that the third pressure blocks external air (or oxygen) from being introduced into the inner space 111.

The third pressure may also be lower than a pressure of the gas flowing in the supply module 120 (or the process gas, in detail, the gas for processing the object). In this case, the protection gas may not flow into the internal chamber IC through a crack even when the crack occurs in the supply line 121 or 125 of the supply module 120 positioned in the inner space 111. Accordingly, a set composition of the gas for processing the object in the internal chamber IC may not be damaged even due to the above-mentioned crack or the like.

The discharge module 150 may discharge a gas from the inner space 111. The gas in the inner space 111 may be mainly the protection gas, and may be a mixture of the process gases. The latter may correspond to a case where the process gas leaks in the supply module 120 or the exhaust module 130.

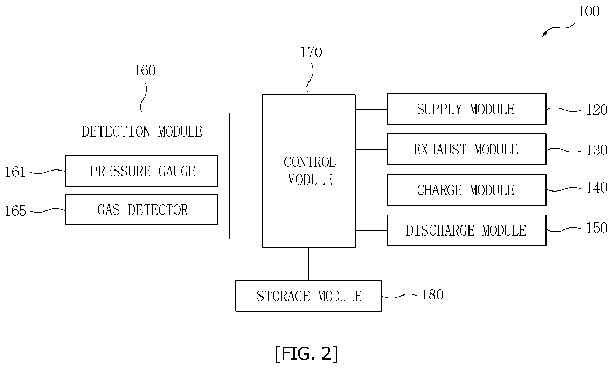

The discharge module 150 may include an exhaust duct 151 communicating with the inner space 111. The exhaust duct 151 may communicate with the utility line (or the gas exhaust line) of the semiconductor factory. A gate valve 155 may be installed in the exhaust duct 151. When the gas in the inner space 111 is required to be exhausted, the gate valve 155 may be opened under control of a control module 170 (see FIG. 2).

The detection module 160 may include a pressure gauge 161 and a gas detector 165 to detect an environment of the inner space 111. The pressure gauge 161 may detect a pressure of the gas in the inner space 111. The gas detector 165 may detect the process gas (in detail, an active gas such as hydrogen) leaking into the inner space 111, and may further detect the gas such as oxygen introduced from the outside.

A control configuration of the gas box assembly 100 is described with reference to FIG. 2. FIG. 2 is a block diagram for explaining the control configuration of the gas box assembly for a high pressure processing apparatus of FIG. 1.

Referring to this drawing (and FIG. 1), the gas box assembly 100 may further include the control module 170, and a storage module 180 in addition to the supply module 120, the exhaust module 130, and the charge module 140, described above.

The control module 170 may control the supply module 120, the exhaust module 130, the charge module 140, the discharge module 150, and the like. The control module 170 may control the charge module 140, the discharge module 150, or the like based on a detection result of the detection module 160.

The storage module 180 may store data, programs, or the like that the control module 170 may refer to for the control.

Through this configuration, the control module 170 can charge the protection gas in the inner space 111 based on the detection result of the detection module 160, or discharge the gas from the inner space 111 as the process gas leaks. The control module 170 can control the charge module 140 for the former, and the control module 170 can control the discharge module 150 for the latter.

The control module 170 may control the charge module 140 together with the discharge module 150 to cause the protection gas to be injected into the inner space 111 when the gas in the inner space 111 is discharged. As a result, process gas concentration can be diluted when the process gas leaks into the inner space 111. The injection of the protection gas may also promote the discharge of the process gas.

The control module 170 can discharge the gas from the inner space 111 and also exhaust the gas from the chamber of the high pressure processing apparatus HA. The reason is that the processing in the chamber can not be performed any longer when a problem occurs due to the leak in the gas box assembly 100. The control module 170 can control the exhaust module 130 to exhaust the gas from the chamber.

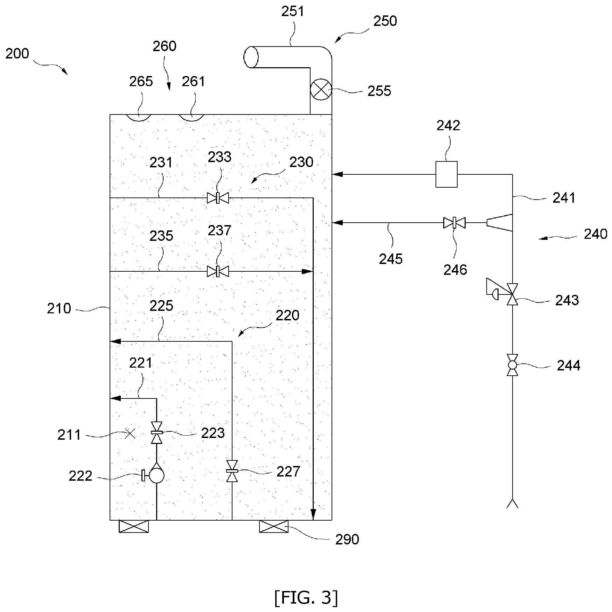

The description describes another type of the gas box assembly 100 with reference to FIGS. 3 to 5.

First, FIG. 3 is a conceptual diagram of a gas box assembly for a high pressure processing apparatus according to another embodiment of the present disclosure.

Referring to this drawing, a gas box assembly 200 is generally the same as the gas box assembly 100 of the embodiment described above, and is somewhat different therefrom in presenting a specific configuration of a charge module 240 and adding an introduction module 290. The description provided with reference to this drawing omits the configuration of the high pressure processing apparatus HA (see FIG. 1).

The charge module 240 may include a regulation line 241 and a bypass line 245 connected to an inner space 211 to supply air to the inner space 211. The regulation line 241 may be directly connected to the utility line (or the gas supply line) of the semiconductor factory, and the bypass line 245 can be branched from the regulation line 241.

A gas regulation charger 242 may be installed in the regulation line 241. The gas regulation charger 242 may supply the protection gas to the inner space 211 in a normal operation mode. The gas regulation charger 242 may serve to maintain a set pressure for the inner space 211 by regulating a supply flow rate of the protection gas. To this end, the gas regulation charger 242 can be controlled based on a pressure detected by a pressure gauge 261.

An emergency open/close charger 246 can be installed in the bypass line 245. The emergency open/close charger 246 may not charge the gas while regulating the supply flow rate of the protection gas. The emergency open/close charger 246 may supply the protection gas to the inner space 211 at a maximum set flow rate in an emergency operation mode {or a mode for discharging the gas from the inner space 211}. The emergency open/close charger 246 may also remain closed in the normal operation mode. The gas leaking into the inner space 211 can be discharged more quickly with being diluted as the protection gas in large quantities is supplied to the inner space 211.

A regulator 243 and a manual valve 244 can also be installed in the regulation line 241. The regulator 243 may regulate the flow rate of the protection gas introduced from the utility line to change the maximum set flow rate. The manual valve 244 is a manual valve to regulate a flow of the protection gas itself through the regulation line 241.

The introduction module 290 may introduce external air into the inner space 211. The introduction module 290 may be a damper that is opened and closed by the control of the control module 170 (see FIG. 2). External air may be introduced into the inner space 211 when the damper is opened while the discharge module 150 is operated.

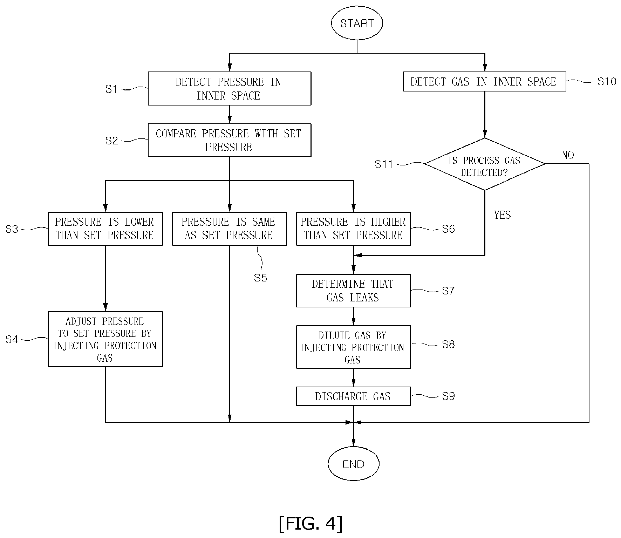

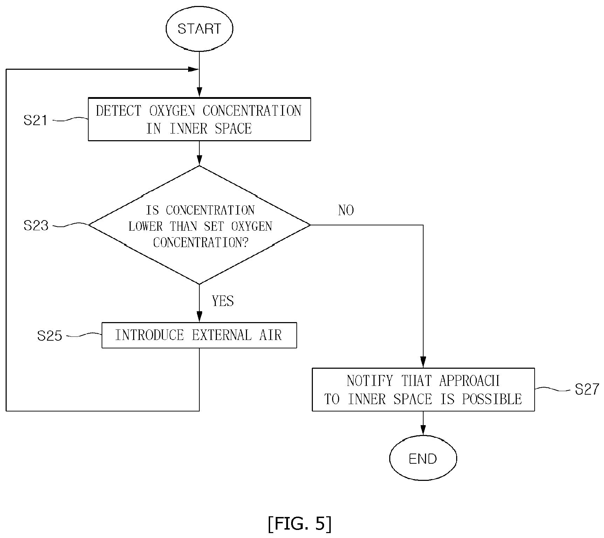

A control method of the gas in the inner space 211 according to the above configuration will be described with reference to FIGS. 4 and 5.

FIG. 4 is a flowchart for explaining a control method of the gas box assembly for a high pressure processing apparatus of FIG. 3.

Referring to this drawing (and FIGS. 2 and 3), the pressure of the gas in the inner space 211 may be detected by the pressure gauge 261 to charge the protection gas to the inner space 211 or discharge the gas from the inner space 211 (S1).

The control module 170 may compare the detected pressure with the set pressure set for the inner space 211 (S2).

When the detected pressure is lower than the set pressure (S3), the control module 170 may control the charge module 240 to additionally inject the protection gas (S4). In detail, the control module 170 may operate the gas regulation charger 242 for the pressure in the inner space 211 to reach the set pressure.

When the detected pressure is the same as the set pressure (S5), this state can be maintained. In this case, the control module 170 may not operate the charge module 240.

When the detected pressure is higher than the set pressure (S6), the control module 170 may determine that a gas leaks (S7). The reason is that the pressure in the inner space 211 is increased as the gas leaks from at least one of a supply module 220 and an exhaust module 230 to the inner space 211. In response to the gas leak, the emergency open/close charger 246 may be operated and the protection gas may be injected into the inner space 211 at the maximum set flow rate. The injection of the protection gas may dilute the concentration of the leaking gas (S8). The diluted leaking gas may be discharged through an exhaust duct 251 by opening a gate valve 255 (S9). When the gas in the inner space 211 is discharged, the gas in the internal chamber IC and the external chamber EC may also be exhausted by exhausted lines 231 and 235.

The gas leak determination (S7), the dilution (S8), and the discharge (S9) may also be made by detecting the gas in the inner space 211 (S10). When a gas detector 265 detects the process gas (S11), the control module 170 may determine that the gas leaks (S7). In this case, the dilution (S8) and the discharge (S9) as described before can be sequentially performed.

FIG. 5 is a flowchart for explaining another control method of the gas box assembly for a high pressure processing apparatus of FIG. 3.

Referring to this drawing, the gas detector 265 can detect oxygen concentration in the inner space 211 to determine whether to allow the worker's approach for maintenance of the gas box assembly 200 (S21).

When the detected oxygen concentration is determined to be lower than set oxygen concentration (S23), external air may be introduced into the inner space 211 (S25). To this end, the control module 170 may control the introduction module 290 to open the damper. In detail, when the gate valve 255 is opened and the inner space 211 has a negative pressure, the damper may be opened and external air may thus flow into the inner space 211, which has a lower pressure than the outside.

When the oxygen concentration in the inner space 211 is determined to be the set oxygen concentration or more (S23), the worker can approach the inner space 211. The control module 170 can notify that the worker can approach the inner space 211 (S27). The notification may be made by visual or auditory means.

By this control, the worker may be allowed to approach the inner space 211 based on the oxygen concentration of the inner space 211 after the gas leaks in the inner space 211 and the exhaust and discharge of the gas in the chamber and inner space 211 of the high pressure processing apparatus HA are completed. In this process, a problem such as worker suffocation can be prevented by ensuring appropriate oxygen concentration.

The gas box assembly for a high pressure processing apparatus as described above is not limited to the configurations and operation methods of the embodiments described above. The embodiments described above may be configured so that various modifications are made by selective combinations of all or some of the respective embodiments.

As set forth above, according to the gas box assembly for a high pressure processing apparatus according to the present disclosure configured as above, the supply module to supply the process gas to the processing chamber and the exhaust module to exhaust the gas processed from the chamber may be installed in the inner space of the housing, and the inner space may be provided with the charge module charging the protection gas at the higher pressure than the external pressure of the housing, thus preventing external air from being introduced into the inner space. As a result, it is possible to structurally eliminate a possibility in which the leaking process gas meets external air (or oxygen) to ignite even if the process gas leaks into the inner space from the supply module or the exhaust module.

## Claims

1. A gas box assembly for a high pressure processing apparatus, the assembly comprising:
a housing having an inner space;
a supply module disposed in the inner space and supplying a process gas to a chamber of the high pressure processing apparatus;
an exhaust module exhausting a gas occurring due to processing of an object in the chamber; and
a charge module charging a protection gas into the inner space at a pressure higher than an external pressure of the housing to block external air from being introduced into the inner space.

2. The assembly of claim 1, wherein a pressure of the inner space by the charging of the protection gas has a value biased toward the external pressure rather than a pressure of the chamber by the supply of the process gas.

3. The assembly of claim 1, wherein a pressure of the inner space by the charging of the protection gas has a value lower than a pressure of the process gas flowing in the supply module.

4. The assembly of claim 1, further comprising:
a detection module detecting an environment of the inner space; and
a control module controlling the charge module,
wherein the control module controls the charge module based on a detection result of the detection module.

5. The assembly of claim 4, wherein the detection module includes a pressure gauge, and
the control module controls the charge module to charge the protection gas for the inner space to reach a set pressure when a pressure of the inner space detected by the pressure gauge is lower than the set pressure.

6. The assembly of claim 1, further comprising:
a detection module detecting an environment of the inner space;
a discharge module discharging a gas from the inner space; and
a control module controlling the discharge module,
wherein the control module operates the discharge module when determining that a gas leaks from at least one of the supply module and the exhaust module to the inner space based on a detection result of the detection module.

7. The assembly of claim 6, wherein the control module controls the charge module to charge the protection gas into the inner space to dilute the leaking gas during a discharge process of the gas from the inner space.

8. The assembly of claim 7, wherein the charge module includes a gas regulation charger charging the protection gas into the inner space while regulating a flow rate of the protection gas.

9. The assembly of claim 7, wherein the charge module includes an emergency open/close charger charging the protection gas at a maximum set flow rate into the inner space during the discharge process of the gas.

10. The assembly of claim 6, wherein the detection module includes at least one of a pressure gauge and a gas detector, and
the control module determines that the gas leaks when a pressure of the inner space detected by the pressure gauge is higher than a set pressure or the gas detector detects the process gas.

11. The assembly of claim 1, further comprising:
a detection module detecting an environment of the inner space;
an introduction module introducing external air into the inner space; and
a control module controlling the introduction module,
wherein the control module controls oxygen concentration in the inner space to reach set oxygen concentration by operating the introduction module based on the oxygen concentration in the inner space that is detected through the detection module.

12. The assembly of claim 1, wherein the object includes a semiconductor wafer,
the process gas includes at least one of hydrogen, deuterium, fluorine, ammonia, and chlorine, and
the protection gas includes an inert gas.

13. A gas box assembly for a high pressure processing apparatus, the assembly comprising:
a housing having an inner space;
an exhaust module disposed in the inner space, and exhausting a gas occurring due to processing of an object in a chamber of the high pressure processing apparatus at a temperature higher than an ignition point of a process gas; and
a charge module charging a protection gas into the inner space at a pressure higher than an external pressure of the housing to block external air from being introduced into the inner space.

14. The assembly of claim 13, further comprising:
a detection module detecting an environment of the inner space;
a discharge module discharging a gas from the inner space; and
a control module controlling the discharge module,
wherein the control module operates the discharge module when determining that a gas leaks from the exhaust module to the inner space based on a detection result of the detection module.

15. The assembly of claim 13, further comprising:
a detection module detecting an environment of the inner space;
an introduction module introducing external air into the inner space; and
a control module controlling the introduction module,
wherein the control module controls oxygen concentration in the inner space to reach set oxygen concentration by operating the introduction module based on the oxygen concentration in the inner space that is detected through the detection module.
